Europäisches Patentamt

(19) European Patent Office

Office européen des brevets

(11) Publication number: **0 210 738**
**A2**

(12) **EUROPEAN PATENT APPLICATION**

(21) Application number: 86304699.1

(22) Date of filing: 18.06.86

(51) Int. Cl.⁴: **H 03 M 3/02**

(30) Priority: 27.07.85 GB 8519012

(43) Date of publication of application:
04.02.87 Bulletin 87/6

(84) Designated Contracting States:
AT BE CH DE FR IT LI LU NL SE

(71) Applicant: PLESSEY OVERSEAS LIMITED
Vicarage Lane
Ilford Essex IGI 4AQ(GB)

(72) Inventor: Iles, Richard Philip Arthur
129 Bure Lane Friars Cliff
Christchurch Dorset BH23 4HB(GB)

(74) Representative: Sorenti, Gino
Intellectual Property Department The Plessey Company
plc 2-60 Vicarage Lane
Ilford Essex IG1 4AQ(GB)

(54) A signal converter.

(57) The signal converter is for converting a formatted input signal into a signal of a different format. The converter includes a data store incorporating a data base containing information relating to the formatting of the conversion. An addressing means is provided for accessing the information stored in the store to generate a store output signal in the converted format.

Fig. 1

EP 0 210 738 A2

TITLE:  A SIGNAL CONVERTER

The present invention relates to a signal converter for converting a formatted input signal into a signal of a different format.

The converter may conveniently be employed to interface a pulse code modulated, PCM communication system with a delta-modulated based voice system, or may conveniently be used to convert A-law PCM signals into linear PCM signals.

In the known forms of converters used hitherto, the digital signals had to be converted into analog form in an intermediate stage before completing the conversion. Converting into analog form introduces the problems of signal noise and distortion, and an increased amount of circuitry is required.  Furthermore, the use of analog conversion in an intermediate stage precludes the use of multiplexing techniques with the known form of circuitry.

Accordingly an aim of the present invention is to provide a converter which does not utilise analog conversion in an intermediate stage, and which does not suffer from the problems experienced in the known form of converter.

According to the present invention there is provided a signal converter for converting a formatted input signal into a signal of a different format, the converter including a data store incorporating a data-base containing information relating to the formatting of the conversion, and addressing means for accessing the information stored in the store to generate a store output signal in the converted format.

According to an aspect of the present invention there is provided a signal converter for converting digital pulse code modulated formatted signals into delta-modulated formatted signals, the converter including a data store incorporating a data-base containing information relating to the formatting of the conversion, and addressing means for accessing the information stored in the data store to generate store output signals in the converted format.

According to a further aspect of the present invention there is provided a signal converter for converting delta-modulated formatted signals into digital pulse code modulated formatted signals, the converter including a data store incorprating a data-base containing information relating to the formatting of the conversion, and addressing means for accessing the information stored in the data store to generate store output signals in the converted format.

According to another aspect of the present invention there is provided a signal converter for converting A-law pulse code modulated formatted signals in N-bit linear pulse code modulated formatted signals, the converter including a data store incorporating a data-base containing information relating to the formatting of the conversion, and addressing means for accessing the information stored in the data store to generate store output signals in the converted format.

According to yet another aspect of the present invention there is provided a signal converter for converting N-bit linear pulse code modulated formatted signals into A-law pulse code modulated formatted signals, the converter including a data store incorporating a data-base containing information relating to the formatting of the conversion, and addressing means for accessing the information stored in the data store to generate output signals in the converted format.

An embodiment of the present invention will now be described with reference to the accompanying drawings wherein:

Figure 1 shows a block diagram of a pulse code modulation to delta-modulation converter,

Figure 2 shows a block diagram of a delta-modulation to pulse code modulation converter,

Figure 3 shows a block diagram of the apparatus used for collecting all combinations of pulse code modulation and delta-modulation samples,

Figure 4 shows a voltage/time graph of an 8KHz samplingsignal for pulse code modulation, and a delta-modulated data stream,

Figure 5 shows a block diagram for correlating data when converting from delta-modulated signals to pulse code modulated signals,

Figure 6 shows a block diagram for correlating data when converting from pulse code modulated signals to delta-modulated signals,

Figure 7 shows a block diagram of an A-law pulse code modulation to linear pulse code modulation converter; and,

Figure 8 shows a block diagram of the apparatus used for collecting all combinations of A-law pulse code modulated samples and linear pulse code modulated samples.

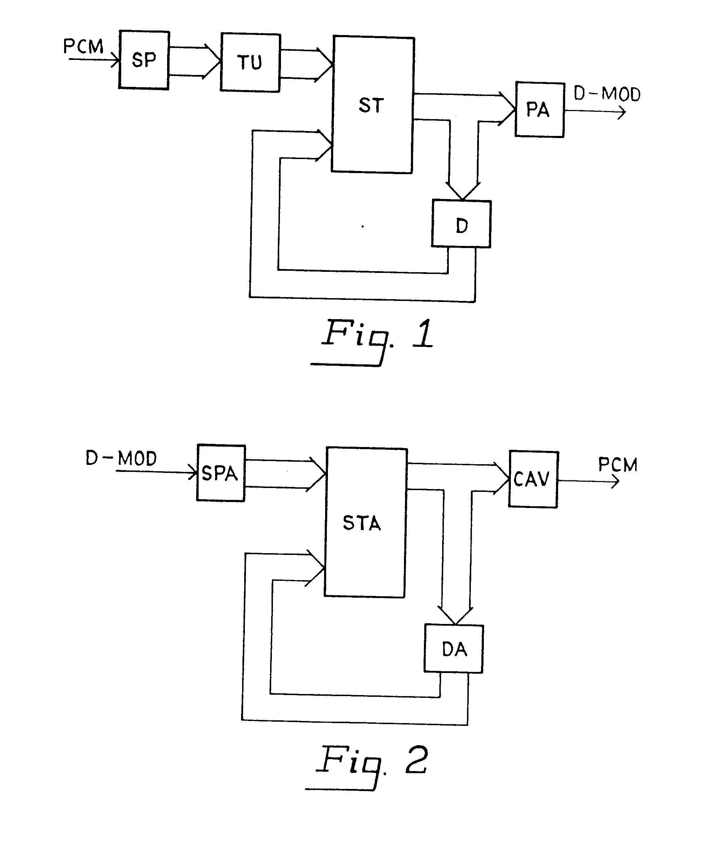

Referring to Figure 1 a pulse code modulation to delta-modulation converter is shown. The PCM signal is converted to parallel form by a serial to parallel converter SP. The parallel outputs from converter SP are presented to circuit TU which calculates the slopes of the PCM signal and generates an interval code related to the current slope of the signal, and the previously calculated interval code. The interval codes form part of an address which is presented to the store ST, and is in the form of a Look-Up table. The store ST contains all the correlated information required to generate output signals in a delta-modulated format, being the conversion of the PCM input signal. The output signal from the store ST comprises four parallel bits which are converted to serial form by a parallel to serial converter PA to form the resultnt delta-modulated code output, D-MOD.

The four output bits from the store ST are also presented to a delay circuit D where they are temporarily stored. The four bits make up the remainder of the store address, and are presented to the address inputs of the store ST simultaneously with the interval codes generated by circuit TU.

Referring to Figure 2, a block diagram of a delta-modulation to pulse code modulation converter is shown. The delta-modulatedsignals D-MOD, are applied to a serial to parallel converter SPA, the output of which generates part of an address which is applied to store STA. The store STA is in the form of a Look-Up table and contains all the correlated information required to generate output signals in a pulse code modulated format. The output signals represent interval codes of the slope of the PCM signal and are passed to a circuit CAV which computes the absolute value of the interval codes and generates a serial PCM output signal which is the conversion of the input delta-modulated signals D-MOD. The previously generated interval codes are temporarily stored in the delay circuit DA and passed to the address input of the store STA as four parallel bits to form the remaining part of the address. The four bits are passed to the store STA simultaneously with the bits generated from the serial to parallel converter SPA.

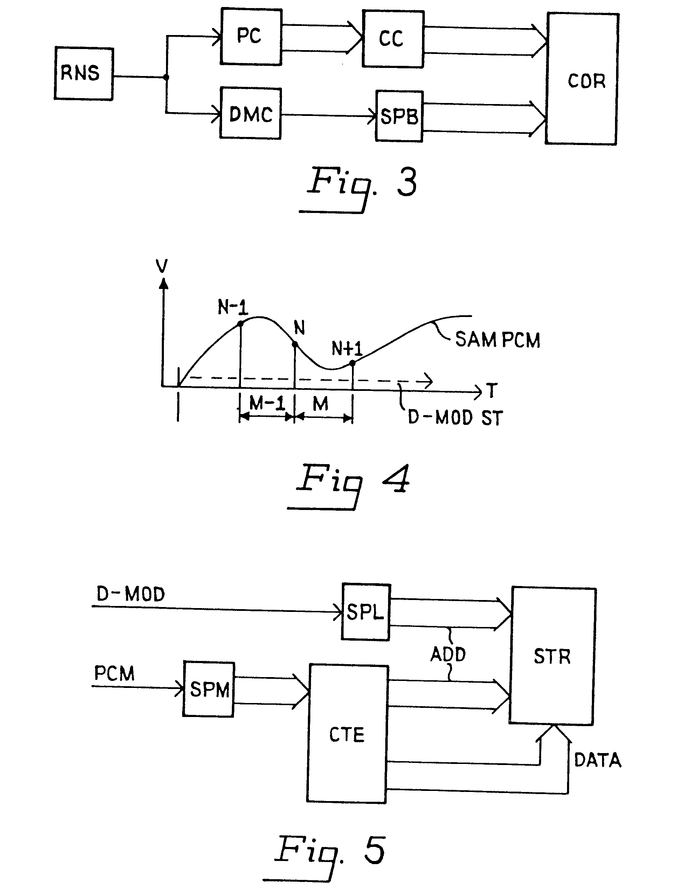

To collect and correlate all combinations of pulse code modulated and delta-modulated samples, the circuit shown in the block diagram of Figure 3 may be used. The data inputs of a reference grade PCM coder/decoder PC and a delta-modulated coder/decoder DMC are driven simultaneously by a randomly varying audio noise source RNS. The coder/decoder PC produces eight parallel output bits which are converted to a twelve bit linear code by a companding corrector CC to remove the A-law companding of PCM data prior to the twelve bits being applied to a correlator COR. The serial output of the coder/decoder DMC is converted to parallel form by a serial to parallel converter SPB prior to being applied to the correlator COR.

The randomly varying audio input from the source RNS ensures that after a sufficient time all combinations of correlation input will occur. The combinations are stored in the stores ST and STA of Figures 1 and 2 respectively, once the data is in the approximate format for each type of conversion. The process may be run until each combination has occurred a number of times and if required the result of each combination may be averaged before storing.

Referring to Figure 4, the conversion process can be likened to plotting on a graph a waveform from information in one code format and then reading off from the graph by interpolation in the other code format. In Figure 4 an 8KHz PCM sampling waveform SAMPCM is shown plotted against voltage V and time T. A delta-modulated data stream D-MOD ST is shown also.

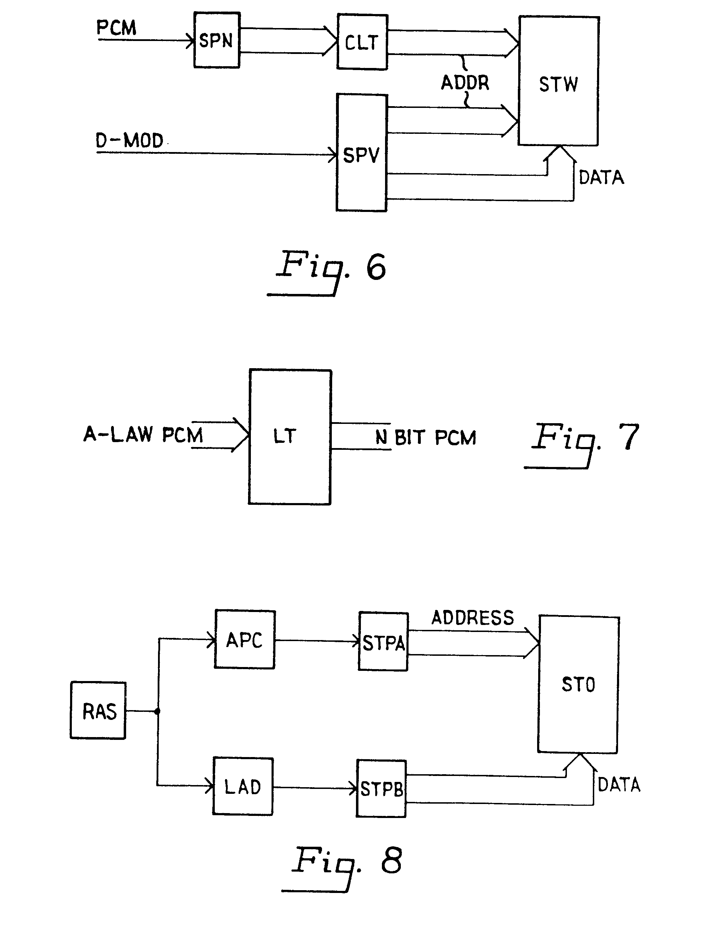

Three sequential samples, N-1, N, N+1 are recorded. The samples N-1, N+1 are computed into offsets with respect to sample N. The combination of the offsets and the previous four bits M-1 of the delta-modulated data stream are used as the address and the present four bits M of the data-modulated data stream as data. In this

- 7 -

0210738

manner the stores ST and STA of Figures 1 and 2 respectively have their content stored with the data formatted for efficient conversion. The manner in which this is achieved is shown in Figures 5 and 6 respectively.

Referring to Figure 4, and to Figure 5 which shows the data correlator when used for collecting data for conversion from delta-modulated signals to pulse code modulated signals. The address ADD for the store STR is formed by eight bits M-1 and M from the delta-modulated signal, generated by way of serial to parallel converter SPL, and four bits representing the previous interval code generated by way of serial to parallel converter SPM and compute circuit CTE. The data which is stored at the given address ADD is eight bits in length and represents the new interval, and is generated by the compute circuit CTE. The total storage required is $2^{(8+4)} \times 8$ bit bytes = 4096 x 8 bit bytes.

Referring to Figure 4, and to Figure 6 which show the data correlator when used for collecting data for conversion from pulse code modulated signals to delta-modulated signals. The address ADDR for the store STW is formed by the pulse code modulated intervals generated by way of serial to parallel converter SPN and interval computation circuit CLT and represented by eight bits of offset and four bits of code representing the slope of the PCM signal at that instant, together with the four previous bits M-1 of the delta-modulated signal which are generated by way of serial to parallel converter SPV. The data which is stored at the given address is M and is four bits in length and is generated by way of the serial to parallel converter SPV. The total storage required is $2^{(8+8)} = 65536$ words of four bits.

The data store can be reduced in size by only storing the maximum and minimum pulse code modulated values that give a certain bit stream in the delta-modulated format. This can be carried out in the correlation process after data collection. The minimum data store size is 256 words of 24 bits. The data is represented by eight bits of offset, together with sixteen bits representing the maximum and minimum values of offset of N-1. The address is represented by eight bits comprising four bits and four bits representing delta-modulated samples.

The data may be collected and correlated by any fast processor, and can be collected and stored in bulk and processed to reduce storage off-line. If bulk storage is limited, the data base may be built up over many on-line, off-line cycles.

The conversion itself is best achieved by a microcontroller with an internal program area accessing a minimum configuration look up table of 4K bytes.

The conversion principles described above may be use to convert an A-law pulse code modulated signal to an N-bit linear signal, where N is any number usually twelve

- 9 -

0210738

or sixteen.

Referring to Figure 7, a store in the form of a look up table LT is used to translate the output of a PCM A-law coder/decoder to an N-bit linear sampling signal. The PCM A-law signal is usually an eight bit signal, and is presented in parallel as one address code to the look up table LT, which may be constituted by a programmable read only memory, and the N-bit result appears as data output.

The look up table data is obtained in accordance with Figure 8. A random audio source drives an A-law PCM coder/decoder APC, and a linear analog to digital converter LAD. Absolute sampling values are used to address the store STO, by way of the coder/decoder APC and the serial to parallel converter STPA. The data is generated by way of converter LAD and serial to parallel converter STPB and is stored at the addressed location in the store STO. The data values may be averaged in the store STO if more than one value is possible.

When converting from an A-law signal to an N-bit linear signal, where N=12, a store of 256 x 12 bits is required composed of an eight bit address and twelve bits of data.

When converting from a linear N-bit signal to an A-law signal a store size of 4096 x 8 bits is required, composed of a twelve bit address and eight bits of data. In this respect the look up table data is obtained using the block diagram shown in Figure 8 modified so that the address is generated by way of the linear analog to

0210738

digital converter, and the data is generated by way of the A-law coder/decoder.

The conversion process described above is not intended to limit the scope of the invention, it can be used to convert any law, for example Mu-law to A-law or to any other law.

CLAIMS

1.    A signal converter for converting a formatted input signal into a signal of a different format, the converter including a data store incorporating a data-base containing information relating to the formatting of the conversion, and addressing means for accessing the information stored in the store to generate a store output signal in the converted format.

2.    A signal converter as claimed in claim 1 wherein, the formatted input signal is in the form of a digital pulse code modulated signal, and the store output signal is in delta-modulated form.

3.    A signal converter as claimed in claim 1 wherein, the formatted input signal is in the form of a delta-modulated signal, and the store output signal is in pulse code modulated form.

4.    A signal converter as claimed in claim 1 wherein, the formatted input signal is in the form of an A-law pulse code modulated signal, and the store output signal is in N-bit linear pulse code modulated form.

5.    A signal converter as claimed in claim 1 wherein, the formatted input signal is in N-bit linear pulse code modulated form, and the store output signal is in A-law pulse code modulated form.

6.    A signal converter as claimed in claim 2 wherein, the addressing means comprises a first circuit for calculating the slopes of the pulse code modulated signal and for generating an interval code related to the

- 12 -

0210738

current slope, and for generating the previously calculated interval code, the addressing means further comprises a second circuit for temporarily storing an output signal from the store and for presenting the signal to the store as·part of an address, simultaneously with the codes generated by the first circuit.

7. A signal converter as claimed in claim 3 wherein, the addressing means comprises a first circuit for presenting the delta-modulated signal in parallel form to the store as part of the store address, and a second circuit for temporarily storing an output signal from the store and for generating an interval code therefrom for presentation·to the store as part of the address, simltaneously with the part address generated by the first circuit.

8. A signal converter as claimed in claim 1, 2 or 3 wherein, the store has the data-base constructed by means of a correlator which receives all combinations of the pulse code modulation samples by means of a pulse code modulated coder/decoder driven by a random noise source and outputting samples to the correlator by way of a companding corrector; and all combinations of delta-modulation samples by means of a delta-modulated coder/decoder driven by the random noise source, and outputting samples to the correlator by way of a serial to parallel converter.

9. A signal converter as claimed in claims 1, 3 and 8 wherein, the correlator includes a compute circuit receiving the pulse code modulation signals and generates a new interval code to be stored at a store address, and an old interval code for use as part of the store address, the remainder of the store address being generated by the delta-modulation signal by way of a serial to parallel converter.

10. A signal converter as claimed in claims 1, 2 and 8 wherein, the correlator includes a serial to parallel converter receiving the delta-modulated signal and generates a new delta-modulation sample for use as part of the store address, the remainder of the store address being generated by the pulse code modulated signal by way of a serial to parallel converter and an interval compute circuit.

11. A signal converter as claimed in claims 1 and 4 wherein, the store data-base is constructed by means of an A-law pulse code modulation coder/decoder driven by a random noise source to generate by way of a serial to parallel converter a store address, and the linear data tobe stored at that address is generated by a linear analog to digital converterdriven by the random noise source and is applied to the store at the addressed location by way of a serial to parallel converter.

12. A signal converter as claimed in claims 1 and 5 wherein, the stored data-base is constructed by means of a linear analog to digital converter driven by a random noise source to generate by way of a serial to parallel converter a store address, and the A-law data to be

- 14 -

0210738

stored is generated by an A-law pulse code modulation
coder/decoder driven by the random noise source and is
applied to the store at the addressed location by way of
a serial to parallel converter.

Fig. 1

Fig. 2

_Fig._ 3

_Fig_ 4

_Fig_ 5

0210738

_Fig._ 6

_Fig._ 7

_Fig._ 8